(19) Europäisches Patentamt

European Patent Office

Office européen des brevets

(11) **EP 0 818 832 B1**

(12) **EUROPÄISCHE PATENTSCHRIFT**

(45) Veröffentlichungstag und Bekanntmachung des Hinweises auf die Patenterteilung:
**08.03.2006 Patentblatt 2006/10**

(51) Int Cl.:
***H01L 39/24*** *(2006.01)*

(21) Anmeldenummer: **97401519.0**

(22) Anmeldetag: **30.06.1997**

(54) **Verfahren zur Erzeugung einer supraleitfähigen Schicht**

Method for the production of a superconductive layer

Procédé de production d'une couche supraconductrice

(84) Benannte Vertragsstaaten:
**DE ES FR GB IT NL SE**

(30) Priorität: **11.07.1996 DE 19627962**

(43) Veröffentlichungstag der Anmeldung:
**14.01.1998 Patentblatt 1998/03**

(73) Patentinhaber: **European High Temperature Superconductors GmbH &
Co. KG
63450 Hanau (DE)**

(72) Erfinder:
• **Freyhardt, Herbert C., Prof. Dr.rer.nat.
37085 Göttingen (DE)**
• **Usoskin, Alexander, Dr.rer.nat.
37085 Göttingen (DE)**
• **Garcia-Moreno, Francisco
37075 Göttingen (DE)**

(74) Vertreter: **Patentanwälte
Westphal, Mussgnug & Partner
Mozartstrasse 8
80336 München (DE)**

(56) Entgegenhaltungen:
EP-A- 0 325 751      EP-A- 0 423 354
DE-C- 4 228 573      US-A- 5 206 216

**Beschreibung**

Die Erfindung bezieht sich auf ein Verfahren zur Erzeugung einer supraleitfähigen Schicht auf einem langgestreckten Substrat, bei welchem das Substrat durch eine Depositionskammer gezogen und innerhalb derselben in einer Heizzone beheizt wird und bei welchem das Substrat in der Heizzone mit supraleitfähigem Material beschichtet wird (DE 42 28 573 C1).

Der Effekt der Supraleitung ist seit langem bekannt. Im Falle der Supraleitung verschwindet - zumindest für Gleichstrom - unterhalb einer bestimmten, kritischen Temperatur der elektrische Widerstand eines metallischen Leiters. Die kritische Temperatur liegt beispielsweise für das Material $Nb_3Sn$ bei 18,2 K. Als Kühlmedium wird üblicherweise Helium verwendet. Elektrischer Strom kann über Supraleiter nahezu verlustlos übertragen werden. Ein Problem ist neben der Erzeugung insbesondere die Aufrechterhaltung der tiefen Temperaturen in der Umgebung des Leiters.

Es wird daher nach supraleitfähigen Materialien gesucht, die bereits bei weniger tiefen Temperaturen supraleitfähig werden. Solche Hochtemperatürsupraleiter (HTSL)-Materialien haben kritische Temperaturen von über 77 K. Sie enthalten beispielsweise die Komponenten Yttrium, Barium, Kupfer und Sauerstofi Die HTSL-Materialien können beispielsweise mittels eines gepulsten Laserstrahls, durch Plasmaverdampfen, thermisches Verdampfen oder chemisch auf ein beheiztes Substrat aufgebracht werden. Gemäß der DE 42 28 573 C1 sind Qualität und Reproduzierbarkeit der mit bekannten Verfahren erzeugten Schichten mangelhaft. Hinzu kommt, daß die Stromtragfähigkeit der Schichten bei Aufrechterhaltung der Supraleitfähigkeit relativ niedrig ist. Die Höhe der übertragbaren Ströme ist dementsprechend begrenzt.

Mit dem bekannten Verfahren nach der eingangs erwähnten DE 42 28 573 Cl werden Qualität und Reproduzierbarkeit der erzeugten HTSL-Schichten verbessert. Die mit einer gepulsten Quelle durchgeführte Beschichtung erfolgt bei diesem Verfahren intermittierend. Es ergeben sich dadurch bei der Beschichtung gleichförmige Temperaturverhältnisse für das Substrat und die aufgepulsten Schichten, wodurch die angegebene Verbesserung erreicht wird. Auch die so erzeugten HTSL-Schichten haben aber eine niedrige Stromtragfähigkeit.

Der EP 0 423 354 A1 ist ein Verfahren zur Herstellung von oxidischen Supraleitern mittels Anlegen eines Drucks in Längsrichtung zu entnehmen.

Der Erfindung liegt die Aufgabe zugrunde, das eingangs geschilderte Verfahren so weiterzuentwickeln, dass eine höhere Stromtragfähigkeit der erzeugten HTSL-Schichten erreicht werden kann.

Diese Aufgabe wird gemäß der Erfindung dadurch gelöst, dass das Substrat in einer gegenüber dem Einsatz des fertigen Produkts derart anderen geometrischen Form mit dem supraleitfähigen Material beschichtet wird, dass in der supraleitfähigen Schicht in der im Einzelfall vorliegenden geometrischen Form des Substrats eine Druckspannung in der Substratebene erzeugt wird, wobei die geometrische Form des substrats während der Beschichtung eine gebogene Form ist.

Bei Einsatz dieses Verfahrens wird das supraleitfähige Material so auf das Substrat aufgebracht, dass es in seiner dem jeweiligen Verwendungszweck entsprechenden Form bzw. Gestalt unter Druckspannung gesetzt wird. Es hat sich überraschend herausgestellt, dass allein durch diese Maßnahme die Stromtragfähigkeit des erzeugten HTSL-Materials wesentlich erhöht wird. Dies ist insbesondere deshalb überraschend, weil ein HTSL-Film im Gegensatz zu keramischem HTSL-Material (DE 37 30 766 A1) eine Mikrostruktur hoher Dichte aufweist mit einer nur geringen interkristallinen Porosität, welche nicht mehr als 0,1 Vol.% beträgt. Eine mögliche Erklärung für die beschriebenen Verbesserungen der kritischen Stromdichten kann dadurch gegeben sein, dass sich eine Veränderung der elektronischen bzw. phononischen Struktur des deformierten Kristalls ergibt, bedingt durch eine Reduktion des a- (b-) Gitterparameters und einen Anstieg des c-Achsen-Parameters. Es könnte auch eine Neuanordnung der Pinning-Zentren im Verlauf der 1-dimensionalen Deformation eintreten. Durch die bei Anwendung dieses Verfahrens möglichen höheren Ströme kann ein entsprechender Supraleiter in neuen bzw. erweiterten technischen Bereichen eingesetzt werden.

Zur Durchführung des Verfahrens wird die supraleitfähige Schicht auf ein im Beschichtungsbereich in seinem Oberflächenbereich gedehntes Substrat aufgebracht das anschließend entspannt wird und damit in seinen ursprünglichen Zustand zurückgeht. Zur Dehnung der Oberfläche wird das Substrat gebogen. Da sich das Substrat nach der Beschichtung zurückbiegt, werden die beschichtete Oberfläche und die aufgebrachte supraleitfähige Schicht mit einer in der Substratebene wirkenden Druckspannung beaufschlagt, so dass sich die erhöhte Stromtragfähigkeit des HTSL-Materials ergibt.

Weitere vorteilhafte Ausgestaltungen der Erfindung gehen aus den Unteransprüchen hervor.

Das Verfahren nach der Erfindung wird an Hand der Zeichnungen in Ausführungsbeispielen erläutert.

Es zeigen:

Fig. 1 in schematischer Darstellung eine Vorrichtung zur Durchführung des Verfahrens nach der Erfindung.

Fig. 2 bis 5 unterschiedliche Möglichkeiten zur Beschichtung eines Substrats

Die supraleitfähige Schicht kann mit jedem bekannten Verfahren auf ein grundsätzlich beliebiges Substrat aufgebracht werden. In der folgenden Beschreibung wird stellvertretend für alle möglichen Verfahren die Beschichtung mit einem gepulsten Laster erläutert. Das Substrat kann unterschiedlich geformt sein. Beispielsweise als Spule, als Spirale oder als Band. Im folgenden wird stellvertretend für alle möglichen Ausführungsformen das Band berücksichtigt.

In einer Depositionskammer 1 - im folgenden kurz "Kammer 1" genannt - wird beispielsweise ein Vakuum erzeugt und aufrechterhalten, in dem beispielsweise eine Sauerstoffatmosphäre mit einem Druck von 0,5 mbar gehalten wird. In der Kammer 1 sind eine Heizzone 2, eine dieselbe umgebende Blende 3, ein elektrischer Motor 4 und ein supraleitfähiges Material tragendes Target 5 angeordnet. Ein von einem gepulsten Laster 6 ausgehender Laserstrahl 7 kann durch ein Fenster 8 in die Kammer 1 eintreten. Der Laserstrahl 7 trifft auf das Target 5. Die rohrförmig ausgebildete Heizzone 2 hat eine Öffnung 9, die durch die drehbar gelagerte Blende 3 geöffnet und verschlossen werden kann. Die Blende 3 ist dazu durch den Motor 4 um ihre Achse drehbar. Das Target 5 kann ebenfalls drehbar in der Kammer 1 angeordnet sein, was durch den Pfeil 10 angedeutet ist. Er ist mit Abstand zur Heizzone 2 vorzugsweise symmetrisch zu einer Linie 11 angebracht, die durch die Mitte der Öffnung 9 verläuft.

Durch die Kammer 1 wird ein Substrat 12 - im folgenden "Band 12" genannt - aus einem beispielsweise mehrkristallinen Material in Richtung der eingezeichneten Pfeile gezogen Es tritt durch eine Öffnung 13 in die Kammer 1 ein, durchläuft die Heizzone 2 und verläßt die Kammer 1 durch eine Öffnung 14. Das Band 12 wird in den Öffnungen 13 und 14 der Kammer 1 durch Rollen 15 und 16 sowie in der Heizzone 2 durch Rollen 17 geführt. Im dargestellten Ausführungsbeispiel sind drei Rollen 17 vorgesehen.

Die Rollen 17 sind in der Heizzone 2 so angeordnet, daß das in seiner Längsrichtung gezogene Band 12 dieselbe gebogen durchläuft. Der Radius der Krümmung des Bandes 12 im gebogenen Bereich ist mit R bezeichnet. Der Scheitelpunkt der Krümmung liegt in Höhe der Öffnung 9 der Heizzone 2 und damit auch in Höhe des Trägers 5.

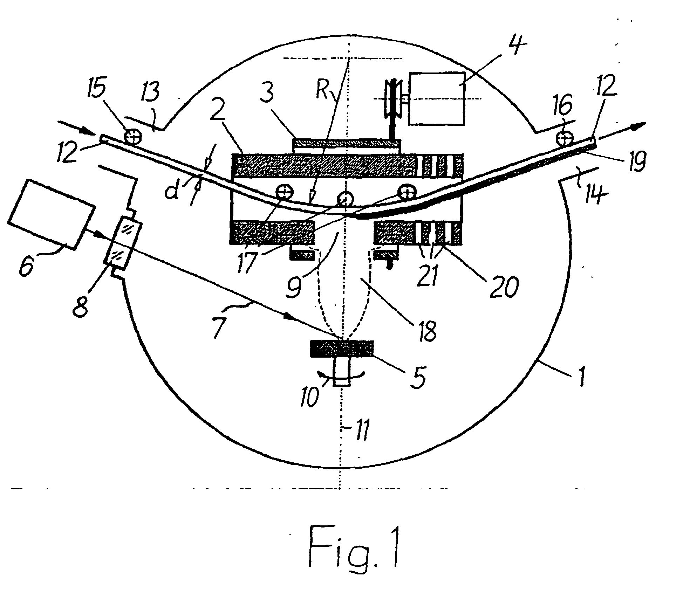

Zur Durchführung des Verfahrens nach der Erfindung mit der aus Fig. 1 ersichtlichen Vorrichtung werden zunächst der Laser 6 und die Heizzone 2 eingeschaltet. Der auf das Target 5 auftreffende Laserstrahl 7 löst aus dessen Oberfläche Partikel des supraleitfähigen Materials, die durch einen gestrichelt angedeuteten Plasmastrahl 18 auf dem Band 12 abgeschieden werden. Das durch die Heizzone 2 gezogene Band 12 erhält dadurch eine Schicht 19 aus supraleitfähigem Material.

Das supraleitfähige Material wird im gebogenen Bereich auf das Band 12 aufgebracht Dieser gebogene Bereich beginnt etwa an der Eintrittstelle des Bandes 12 in die Heizzone 2. Er endet etwa in deren Austrittsbereich 20, in welchem vorzugsweise eine verminderte Heizleistung erzeugt wird. Das ist durch die eingezeichneten Durchbrechungen 21 angedeutet. Im Austrittsbereich 20 der Heizzone 2 wird das mit der Schicht 19 versehene Band 12 also bereits abgekühlt. Dadurch ist die Verbindung zwischen Band 12 und Schicht 19 ausreichend fest, wenn das Band 12 wieder geradlinig ausgerichtet wird. Die dadurch bewirkte Stauchung der beschichteten Oberfläche des Bandes 12 einerseits und der Schicht 19 andererseits bewirkt die erhöhte Stromtragfähigkeit des fertiggestellten HTSL-Bandes.

Während der Beschichtung kann die Blende 3 durch den Motor 4 um ihre Achse gedreht werden. Sie wirkt dadurch als rotierende Infrarotabschirmung, die mit den Laserpulsen derart synchronisiert ist, daß sie das Band 12 periodisch für einen kurzen Zeitraum freigibt. In diesem Zeitraum erfolgt jeweils der Materialübertrag vom Target 5 zum Band 12 durch einen Partikelstrahl. Es werden auf diese Weise entsprechend der DE 42 28 573 C1 verbesserte Temperaturbedingungen im Abscheidungsbereich erzielt. Qualität und Reproduzierbarkeit der Abscheidung werden dadurch verbessert.

Durch die Biegung des Bandes 12 innerhalb der Heizzone 2 erfährt dasselbe eine Dehnung, die etwa zwischen 0,01% und 0,6 % liegt. Die jeweilige Dehnung des Bandes 12 läßt sich nach der Gleichung

$$R = d/2\delta$$

berechnen. Darin sind R der Krümmungsradius, d die Dicke des Bandes 12 und δ eine absolute Deformationszalal, die zwischen 0,0001 und 0,006 liegt.

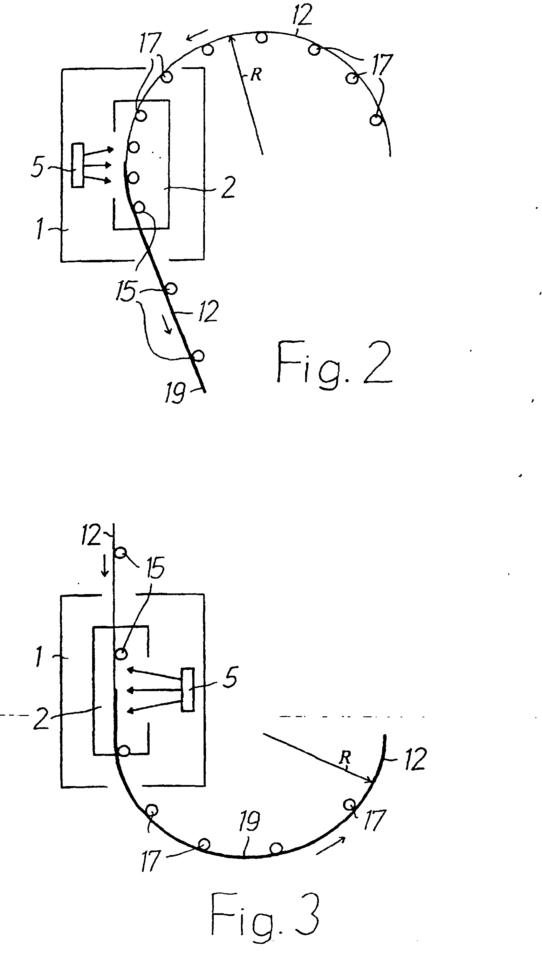

In den Fig. 2 bis 5 sind unterschiedliche Möglichkeiten zur Formung des Bandes 12 während der Beschichtung und des mit der supraleitfähigen Schicht 19 versehenen Bandes 12 in mehreren Anwendungen dargestellt. Dabei sind gleiche Teile wie in Fig. 1 mit den gleichen Bezugszeichen versehen.

Fig. 2 zeigt eine Anordnung, die i. w. der Vorrichtung nach Fig. 1 entspricht. Das Band 12 wird über eine Anzahl von Rollen 17 in gebogenem Zustand in Richtung der eingezeichneten Pfeile durch die Heizzone 3 gerührt. Es wird dabei um einen Radius R gebogen, welcher der Gleichung

$$R = 2k/d$$

genügt. d ist darin die Dicke des Bandes 12. Der Faktor k berücksichtigt die zulässige Dehnung des Bandes 12. Sie liegt zwischen 0,001 % und 0,6 %. In der Heizzone 2 wird das Band 12 mit dem supraleitfähigen Material beschichtet. Das mit der supraleitfähigen Schicht 19 versehene Band 12 wird nach Verlassen der Heizzone 2 durch die Rollen 15 geradlinig ausgerichtet. Das supraleitfähige Material wird dabei zusammengedrückt. Der so hergestellte HTSL-Supraleiter hat bei Verwendung in geradlinigem Zustand eine erhöhte Stromtragfähigkeit.

Bei der Anordnung nach Fig. 3, die nicht Teil der Erfindung ist, wird das in Richtung der eingezeichneten Pfeile bewegte Band 12 durch die Rollen 15 geradlinig in die Heizzone 2 geführt und in derselben mit dem supraleitfähigen Material beschichtet. Nach Verlassen der Heizzone 2 wird das Band 12 durch die Rollen 17 wieder um den Radius R gebogen. Dabei liegt die supraleitfähige Schicht 19 innen, so daß ihr Material zusammengedrückt wird. Der gebogene HTSL-Supraleiter kann höhere Ströme führen

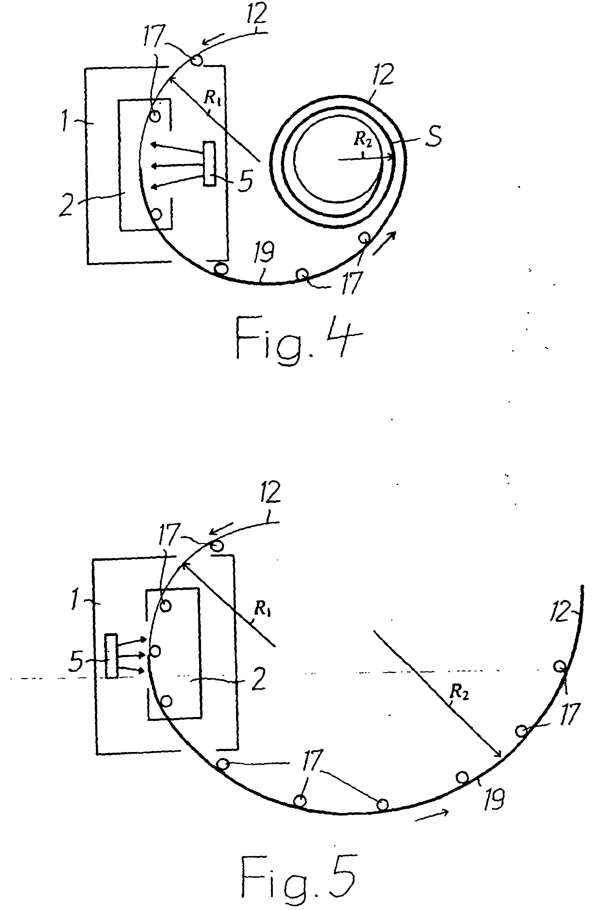

Bei der Ausführungsform nach Fig. 4 wird das über die Rollen 17 geführte und mit dem Radius $R_1$ gebogene Band 12 in Richtung der eingezeichneten Pfeile durch die Heizzone 2 gezogen. Es wird bezüglich der Biegung innen mit supraleitfähigem Material beschichtet. Das mit der supraleitfähigen Schicht 19 versehene Band 12 wird anschließend mit einem Radius $R_2$ zu einer Spule gewickelt. $R_2$ ist kleiner als $R_1$. Das Material der Schicht 19 wird also in der Spule S unter Druckspannung gesetzt. Die supraleitfähige Spule S hat eine erhöhte Stromtragfähigkeit.

Im Gegensatz zu Fig. 4 wird das Band 12 bei der Anordnung nach Fig. 5 außen mit dem supraleitfähigen Material beschichtet. Es wird mit dem Radius $R_1$ gebogen durch die Heizzone 2 gezogen und anschließend auf den Radius $R_2$ "aufgeweitet", der größer als $R_1$ ist. Das Material der supraleitfähigen Schicht 19 wird dabei zusammengedrückt. Auch dieser HSTL-Supraleiter kann höhere Ströme führen.

Für die Radien $R_1$ und $R_2$ gilt das Verhältnis

$$R_1/R_2 = [1 \pm 2kR_2/d]^{-1}$$

Darin sind d die Dicke des Bandes 12 und k ein die Dehnung desselben berücksichtigender Faktor. Das + Zeichen gilt bei Außenbeschichtung entsprechend Fig. 5 und das - Zeichen für Innenbeschichtung nach Fig 4.

Das Band 12 kann beispielsweise eine 0,12 mm dicke Nickelfolie oder eine 0,125 mm dickes Band aus einer mit Yttrium stabilisierten Zirkonkeramik sein. Beide "Substrate" sind mit einer Pufferschicht aus mit Yttrium stabilisiertem Zirkon versehen. Die Temperatur im Abscheidungsbereich liegt bei etwa 770 °C. Sie beträgt im Austrittsbereich 20 etwa 20 °C bis 400 °C. Die Schicht 19 wird mit einer Rate von 0,5 bis 1,0 nm/s aufgebaut. Das Band 12 wird mit einer Geschwindigkeit von 0,8 cm/h gezogen. Als Material für das Band 12 kann auch bimetallisches Material eingesetzt werden, bei dem sich eine Krümmung automatisch bei unterschiedlichen Temperaturen während der Beschichtung und im Einsatzfall ergibt.

Das Verfahren nach der Erfindung fuhrt zu den folgenden, in zwei Beispielen angegebenen Ergebnissen:

**Beispiel 1**

Eine 0,12 mm dicke Nickelfolie wird im Beschichtungsbereich mit einem Krümmungsradius R von 40 mm gebogen. Die Zahl δ beträgt 0,0015. Für das fertiggestellte HTSL-Band ergeben sich eine kritische Temperatur von 89,2 K und eine Stromtragfähigkeit von 1,8 x $10^6$ A/cm$^2$. Die Stromtragfähigkeit liegt etwa um den Faktor 2 höher als bei der bisherigen Technik.

**Beispiel 2**

Ein 0,125 mm dickes Band aus einer mit Yttrium stabilisierten Zirkonkeramik wird im Beschichtungsbereich mit einem Krümmungsradius R von 30 mm gebogen. Die Zahl δ beträgt 0,0021. Für das fertiggestellte HTSL-Band ergeben sich eine kritische Temperatur von 89,8 K und eine Stromtragfähigkeit von 0,4 x $10^6$ A/cm$^2$. Die Stromtragfähigkeit liegt etwa um den Faktor 1,4 höher als bei der bisherigen Technik.

**Patentansprüche**

1. Verfahren zur Erzeugung einer supraleitfähigen Schicht aus einem Hochtemperatursupraleiter-Material auf einem langgestreckten Substrat, bei welchem das Substrat durch eine Depositionskammer gezogen und innerhalb derselben in einer Heizzone beheizt wird und bei welchem das Substrat in einer ersten geometrischen Form in der Heizzone mit supraleitfähigem Material beschichtet wird, bei welchem das beschichtete Substrat (12) nach der Beschichtung gekühlt wird, und bei welchem das beschichtete Substrat (12) in eine zweite geometrische Form gebracht wird, die im Einsatzfall vorliegt, die von der ersten geometrischen Form abweicht, und in der in der supraleitfähigen Schicht in der Substratebene eine Druckspannung erzeugt wird, wobei die erste geometrische Form eine gebogene Form ist.

2. Verfahren nach Anspruch 1, **dadurch gekennzeichnet,**
**dass** die Oberfläche des Substrats (12) zur Erzielung der ersten geometrischen Form während der Beschichtung mit dem supraleitfähigen Material durch Biegen gedehnt wird und dass das beschichtete Substrat nach seiner Abkühlung zur Erzielung der zweiten geometrischen Form derart zurückgebogen wird, dass seine beschichtete Oberfläche entspannt und in der supraleitfähigen Schicht in der Substratebene eine Druckspannung erzeugt wird.

3. Verfahren nach Anspruch 2, **dadurch gekennzeichnet, dass**
der Bereich der mechanischen Dehnung des Substrat (12) vor der Beschichtung beginnend bis in einen der Heizzone (2) folgenden Kühlbereich erstreckt wird.

4. Verfahren nach Anspruch 2 oder 3, **dadurch gekennzeichnet, dass** das unter Zugspannung stehende Substrat (12) im Beschichtungsbereich über Rollen (17) geführt und gebogen wird.

5. Verfahren nach Anspruch 1, **dadurch gekennzeichnet,**
dass das Substrat (12) zunächst mit einem Radius $R_1$ gebogen wird,
dass das Substrat (12) danach, während das Substrat eine gebogene Form hat, mit dem supraleitfähigen Material beschichtet wird und
dass das beschichtete Substrat (12) im Einsatzfall um einen Radius $R_2$ gebogen wird, der vom Radius $R_1$ abweicht.

6. Verfahren nach einem der Ansprüche 1 bis 5, **dadurch gekennzeichnet, dass** ein aus einem mehrkristallinen Material bestehendes Substrat (12) verwendet wird.

7. Verfahren nach einem der Ansprüche 1 bis 6, **dadurch gekennzeichnet, dass** als Substrat (12) eine Nikkelfolie verwendet wird.

8. Verfahren nach einem der Ansprüche 1 bis 6, **dadurch gekennzeichnet, dass** als Substrat (12) ein Band aus mit Yttrium stabilisierter Zirkonkeramik verwendet wird.

9. Verfahren nach einem der Ansprüche 1 bis 6, **dadurch gekennzeichnet, dass** als Substrat (12) bimetallisches Material verwendet wird.

10. Verfahren nach einem der Ansprüche 1 bis 9, **dadurch gekennzeichnet, dass** das Substrat (12) beim Biegen zwischen 0,01% und 0,6% linear verformt wird.

11. Verfahren nach einem der Ansprüche 1 bis 10, **dadurch gekennzeichnet, dass** das beschichtete Substrat (12) beim Zusammendrücken der supraleitfähigen Schicht (19) einer Temperatur von bis zu 400°C ausgesetzt wird.

**Claims**

1. Method of producing a superconductive layer of a high-temperature superconductor material on an elongated substrate, in which the substrate is drawn through a deposition chamber and is heated in a heating zone within the latter, in which the substrate is coated with superconductive material in the heating zone while it has a first geometric shape, in which the coated substrate (12) is cooled after the coating operation and in which the coated substrate (12) is given a second geometric shape which obtains while it is used, which differs from the first geometric shape and in which compressive stress is produced in the superconductive layer in the substrate plane, the first geometric shape being a bent shape.

2. Method according to claim 1, **characterised in that** the surface of the substrate (12) is stretched by bending while it is being coated with the superconductive material in order to obtain the first geometric shape and that the coated substrate is bent back after the cooling thereof in order to obtain the second geometric shape, in such a manner that its coated surface is relaxed and compressive stress is produced in the superconductive layer in the substrate plane.

3. Method according to claim 2, **characterised in that** the region of the mechanical strain of the substrate (12) begins before the coating region and extends to a cooling region following the heating zone (2).

4. Method according to claim 2 or claim 3, **characterised in that** the substrate (12) subjected to tensile stress is guided via rollers (17) and bent in the coating region.

5. Method according to claim 1, **characterised in that** the substrate (12) is first bent with a radius $R_1$, that the substrate (12) is then coated with the superconductive material while the substrate has a bent shape and that that the coated substrate (12) is bent by a radius $R_2$ which differs from the radius $R_1$ while it is used.

6. Method according to one of claims 1 to 5, **characterised in that** a substrate (12) consisting of a polycrystalline material is used.

7. Method according to one of claims 1 to 6, **characterised in that** a nickel foil is used as the substrate (12).

8. Method according to one of claims 1 to 6, **characterised in that** an yttrium-stabilised zircon ceramic strip is used as the substrate (12).

9. Method according to one of claims I to 6, **characterised in that** bimetallic material is used as the substrate (12).

10. Method according to one of claims 1 to 9, **characterised in that** the substrate (12) is deformed linearly between 0.01 % and 0.6 % during the bending operation.

11. Method according to one of claims 1 to 10, **characterised in that** the coated substrate (12) is subjected to a temperature of up to 400°C during the compression of the superconductive layer (19).

## Revendications

**1.** Procédé de production d'une couche supraconductrice à partir d'un matériau supraconducteur à haute température sur un substrat allongé, selon lequel on tire le substrat par une chambre de dépôt où il est chauffé dans une zone de chauffe et revêtu d'un matériau supraconducteur dans une première forme géométrique dans cette zone de chauffe, le substrat revêtu (12) est refroidi après le revêtement, et amené dans une deuxième forme géométrique correspondante à l'utilisation et qui s'écarte de la première forme géométrique, et dans laquelle une contrainte de compression est produite dans la couche supraconductrice dans le plan du substrat, la première forme géométrique étant une forme courbée.

**2.** Procédé selon la revendication 1,
**caractérisé en ce que**
la surface du substrat (12) est étirée par flexion pour obtenir la première forme géométrique pendant le revêtement avec le matériau supraconducteur et le substrat revêtu est recourbé après son refroidissement pour obtenir la deuxième forme géométrique de manière à ce que sa surface revêtue soit détendue et qu'une contrainte de compression soit générée dans la couche supraconductrice dans le plan du substrat.

**3.** Procédé selon la revendication 2,
**caractérisé en ce que**
la zone d'étirement mécanique du substrat (12) s'étend du revêtement jusqu'à une zone de refroidissement succédant à la zone de chauffe (2).

**4.** Procédé selon la revendication 2 ou 3,
**caractérisé en ce qu'**
avant le revêtement le substrat (12) lors de l'effort de traction est guidé et plié dans la zone via des rouleaux (17).

**5.** Procédé selon la revendication 1,
**caractérisé en ce que**
le substrat (12) est tout d'abord courbé avec un rayon $R_1$, il est ensuite revêtu du matériau supraconducteur pendant qu'il a une forme courbe et le substrat revêtu (12) est courbé lors de l'utilisation suivant un rayon $R_2$ s'écartant du rayon $R_1$.

**6.** Procédé selon l'une quelconque des revendications 1 à 5,
**caractérisé en ce qu'**
on utilise un substrat (12) se composant d'un matériau polycristallin.

**7.** Procédé selon l'une quelconque des revendications 1 à 6,
**caractérisé en ce qu'**
on utilise une feuille de nickel en tant que substrat (12).

**8.** Procédé selon l'une quelconque des revendications 1 à 6,
**caractérisé en ce qu'**
une bande en céramique de zircone stabilisée à l'yttrium sert de substrat (12).

**9.** Procédé selon l'une quelconque des revendications 1 à 6,
**caractérisé en ce qu'**
un matériau bimétallique sert de substrat (12).

**10.** Procédé selon l'une quelconque des revendications 1 à 9,
**caractérisé en ce que**
le substrat (12) est déformé de manière linéaire entre 0,01 % et 0,6 % lors de la flexion.

**11.** Procédé selon l'une quelconque des revendications 1 à 10,
**caractérisé en ce que**
le substrat (12) revêtu est exposé à une température pouvant aller jusqu'à 400°C lors de la compression de la couche supraconductrice (19).

Fig.1

Fig. 2

Fig. 3

Fig. 4

Fig. 5